# EUROPEAN PATENT APPLICATION

(11) **EP 4 658 041 A1**
(43) Date of publication of application: **03.12.2025**
(21) Application number: 25177744.7
(22) Date of filing: 20.05.2025
(51) Int. Cl.: H10K 50/16, H10K 59/88

(54) **DISPLAY DEVICE AND MANUFACTURING METHOD THEREOF**

(30) Priority: 31.05.2024 KR 20240071551
(71) Applicant: Samsung Display Co., Ltd., Gyeonggi-do (KR)
(72) Inventor: PARK, Jongjang, Yongin-si (KR); JEONG, Seunghwa, Yongin-si (KR)
(74) Representative: Marks & Clerk LLP

(57) **Abstract**

A display device includes a substrate including a display area and a non-display area, a light emitting element disposed in the display area and a dummy printing area disposed in the non-display area, wherein the light emitting element includes quantum dots, and wherein an acid ink is disposed in the dummy printing area.

## Description

### BACKGROUND

### 1. Field

The invention relates to a display device and more particularly, to a display device for simplifying an acid treatment process and a method for manufacturing the display device.

### 2. Description of the Related Art

A light emitting device includes an anode, a cathode, and a light emitting layer formed between them, where holes injected from the anode and electrons injected from the cathode combine in the light emitting layer to produce excitons, which are changed to a ground state from an excited state, releasing energy to emit light.

Since the light emitting device may be driven with low voltage, it may be configured to be lightweight and thin, and may have excellent characteristics such as viewing angle, contrast, and response speed, a range of applications thereof is increasing from personal portable devices to televisions (TV).

### SUMMARY

The present invention provides a display device for simplifying an acid treatment process and for increasing efficiency, and a manufacturing method thereof.

An embodiment of the invention provides a display device including a substrate including a display area and a non-display area, a light emitting element disposed in the display area and a dummy printing area disposed in the non-display area, wherein the light emitting element includes quantum dots, and wherein an acid ink is disposed in the dummy printing area.

In an embodiment, the acid ink may include a polymer resin and an acid material.

In an embodiment, the acid material may include at least one of methacrylic acid, acrylic acid, and citric acid.

In an embodiment, the acid ink may be disposed on a predetermined portion of the dummy printing area and may not be disposed on another predetermined portion thereof.

In an embodiment, the display device may further include a thickness measuring groove disposed in the non-display area, wherein the acid ink may be disposed in the thickness measuring groove.

In an embodiment, the display device may further include a thickness measuring groove disposed in the display area, wherein the acid ink is disposed in the thickness measuring groove.

In an embodiment, the light emitting element may include a first electrode, a hole transport layer, a light emitting layer, an electron transport layer, and a second electrode, and the light emitting layer may include quantum dots.

In an embodiment, the electron transport layer may include ZnO and ZnMgO.

In an embodiment, the acid ink may discharge acid vapor.

In another embodiment, the invention provides a method for manufacturing the display device including preparing a substrate including a display area and the non-display area, forming the light emitting element in the display area and printing the acid ink in the non-display area.

In an embodiment, the non-display area may include the dummy printing area, wherein the acid ink may be printed in the dummy printing area.

In an embodiment, the acid ink may be disposed on a predetermined portion of the dummy printing area and may not be disposed on another predetermined portion thereof.

In an embodiment, the acid ink may include a polymer resin and an acid material.

In an embodiment, the acid material may include at least one of methacrylic acid, acrylic acid, and citric acid.

In an embodiment, the method may further include a thickness measuring groove disposed in the non-display area, wherein the method may further include printing an acid ink in the thickness measuring groove.

In an embodiment, the method may further include a thickness measuring groove disposed in the display area, wherein the method may further include printing an acid ink in the thickness measuring groove.

In an embodiment, the light emitting element may include the first electrode, the hole transport layer, the light emitting layer, the electron transport layer, and the second electrode, and the light emitting layer may include quantum dots.

In an embodiment, the electron transport layer may include ZnO and ZnMgO.

In an embodiment, the acid ink may discharge acid vapor.

In an embodiment, the light emitting element may be aged by the acid vapor.

At least some of the above and other features of the invention are set out in the claims.

According to an embodiment, the display device for simplifying the acid treatment process and for increasing efficiency and the manufacturing method thereof are provided.

### BRIEF DESCRIPTION OF THE DRAWINGS

FIG. 1 shows a panel of a display device, according to an embodiment.
FIG. 2 shows a cross-sectional view of a light emitting element on a display area, according to an embodiment.
FIG. 3 shows a stacking structure of a light emitting element on a display area of FIG. 2, according to an embodiment.
FIG. 4 shows an aging process, according to an embodiment.
FIG. 5 shows an aging process, according to an embodiment.
FIG. 6 shows an aging process, according to an embodiment.
FIG. 7 shows an aging process, according to an embodiment.
FIG. 8 shows a defect emission of a light emitting element, according to multiple embodiments (Embodiment 1 to Embodiment 4).
FIG. 9 shows a driving voltage (V) which depends on whether or not an acid treatment is performed, according to an embodiment.
FIG. 10 shows an efficiency (Cd/A) which depends on whether or not an acid treatment is performed, according to an embodiment.
FIG. 11 shows a life-span T90 which depends on whether or not an acid treatment is performed, according to an embodiment.
FIG. 12 shows the same region as that shown in FIG. 1, according to another embodiment.
FIG. 13 shows the same region as that shown in FIG. 1, according to another embodiment.
FIG. 14 shows the same region as that shown in FIG. 12, according to another embodiment.
FIG. 15 shows the same region as that shown in FIG. 1, according to another embodiment.
FIG. 16 shows a process for manufacturing a display device, according to an embodiment.
FIG. 17 shows a stage for printing an acid ink in a non-display area, according to an embodiment.

### DETAILED DESCRIPTION

The invention will be described more fully hereinafter with reference to the accompanying drawings, in which embodiments of the invention are shown. As those skilled in the art would realize, the described embodiments may be modified in various different ways, all without departing from the scope of the invention.

The drawings and description are to be regarded as illustrative in nature and not restrictive, and like reference numerals designate like elements throughout the specification.

The size and thickness of each configuration shown in the drawings are arbitrarily shown for better understanding and ease of description, but the invention is not limited thereto. The thicknesses of layers, films, panels, regions, etc., are enlarged for clarity. For ease of description, the thicknesses of some layers and areas are exaggerated.

It should be understood that when an element such as a layer, film, region, or substrate is referred to as being "on" another element, it can be directly on the other element or intervening elements may also be present. In contrast, when an element is referred to as being "directly on" another element, there are no intervening elements present. It should be understood that when an element such as a layer, film, region, or substrate is referred to as being "on" another element, it can be directly on the other element or intervening elements may also be present.

Unless explicitly stated to the contrary, the word "comprise," and variations such as "comprises" or "comprising", should be understood to imply the inclusion of stated elements but not the exclusion of any other elements.

The phrase "in a plan view" means viewing an object portion from the top, and the phrase "in a cross-sectional view" means viewing a cross-section of which the object portion is perpendicularly cut from the side.

A display device and a method for manufacturing a display device, according to an embodiment, will now be described.

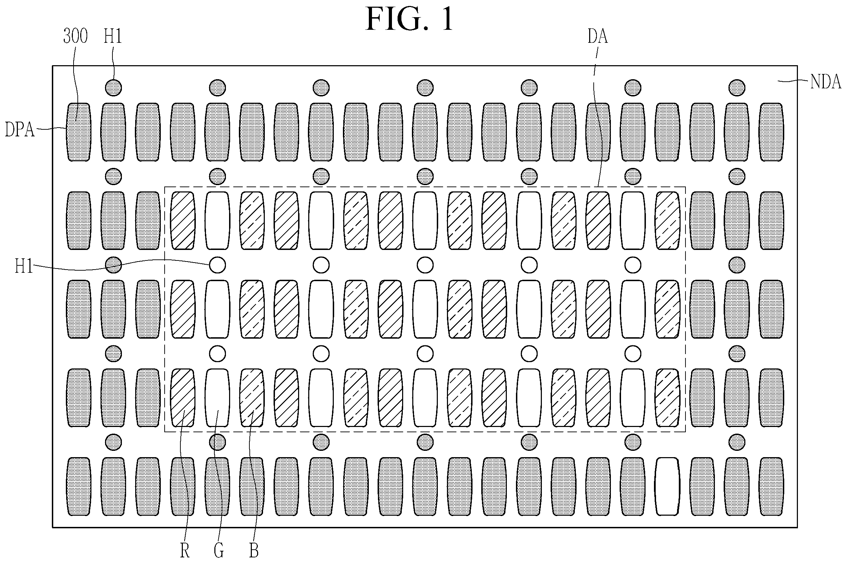

FIG. 1 shows a panel of a display device, according to an embodiment. In an embodiment and referring to FIG. 1, the display device includes a display area DA and a non-display area NDA, where a light emitting element including quantum dots is disposed in the display area DA. FIG. 1 shows a red pixel (R), a blue pixel (B), and a green pixel (G) disposed in the display area DA. As will be described in detail below, the light emitting elements included in each of the red pixel (R), blue pixel (B), and green pixel (G) may include light emitting elements for emitting red, blue, and green light, respectively.

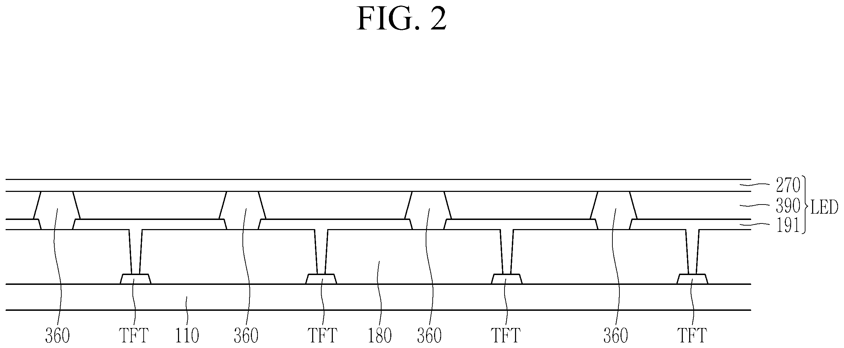

In an embodiment of the display device, the light emitting element disposed in the display area DA may include quantum dots on a light emitting layer. FIG. 2 shows a cross-sectional view of an embodiment of a display area DA. In an embodiment and referring to FIG. 2, the display device may include a first substrate 110, and transistors TFT and an insulating layer 180 disposed on the first substrate 110. A first electrode 191 and a partition wall 360 may be disposed on the insulating layer 180, and the first electrode 191 may be disposed on an opening of the partition wall 360 and may be connected to the transistor TFT. Although not shown in detail, the transistor TFT may include a semiconductor layer, a source electrode and a drain electrode connected to the semiconductor layer, and a gate electrode insulated from the semiconductor layer. A second electrode 270 may be disposed on the partition wall 360, and a light emitting layer 390 may be disposed between the first electrode 191 and the second electrode 270. The first electrode 191, the second electrode 270, and the light emitting layer 390 configure a light emitting diode LED, where the light emitting layer 390 may include quantum dots. The light emitting elements for emitting light of each color may include different quantum dots.

In an embodiment, the light emitting layer 390 may include quantum dots. For example, the quantum dots may include at least one of Zn, Te, Se, Cd, In, and P. The quantum dots may include a core containing at least one of Zn, Te, Se, Cd, In, and P, and a shell disposed on a portion of the core and having a composition that is different from that of the core.

In detail, in an embodiment, the quantum dots may be selected from among a Group II-VI compound, a Group I-III-VI compound, a Group III-V compound, a Group IV-VI compound, a Group IV element, a Group IV compound, and combinations thereof.

The quantum dots may be selected from among a binary compound including CdSe, CdTe, CdS, ZnS, ZnSe, ZnTe, ZnO, HgS, HgSe, HgTe, MgSe, MgS that are the Group II-VI compound, and mixtures thereof, such as a tertiary compound including CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, and MgZnS, and mixtures thereof, such as and a quaternary compound including HgZnTeS, CdZnSeS, CdZnSeTe, CdZnSTe, CdHgSeS, CdHgSeTe, CdHgSTe, HgZnSeS, HgZnSeTe, and HgZnSTe, and mixtures thereof.

The quantum dots may be selected from among a tertiary compound including AgInS, CuInS, AgGaS, CuGaS that are the Group I-III-VI compound, and mixtures thereof, and a quaternary compound including AgInGaS and CuInGaS.

The Group III-V compound may be selected from among a binary compound including GaN, GaP, GaAs, GaSb, AlN, AlP, AlAs, AlSb, InN, InP, InAs, and InSb, and mixtures thereof, a tertiary compound including GaNP, GaNAs, GaNSb, GaPAs, GaPSb, AlNP, AlNAs, AlNSb, AlPAs, AlPSb, InGaP, InAlP, InNP, InNAs, InNSb, InPAs, and InPSb, and mixtures thereof, and a quaternary compound including GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, and InAlPSb, and mixtures thereof, and the Group III-V compound may further include the Group II metal (e.g., InZnP) and may be selected from among the compounds.

The Group IV-VI compound may be selected from among a binary compound including SnS, SnSe, SnTe, PbS, PbSe, and PbTe, and mixtures thereof, a tertiary compound including SnSeS, SnSeTe, SnSTe, PbSeS, PbSeTe, PbSTe, SnPbS, SnPbSe, and SnPbTe, and mixtures thereof, and a quaternary compound including SnPbSSe, SnPbSeTe, and SnPbSTe, and mixtures thereof. The Group IV element may be selected from among Si, Ge, and a mixture thereof, and the Group IV compound may be a binary compound including SiC, SiGe, and a mixture thereof.

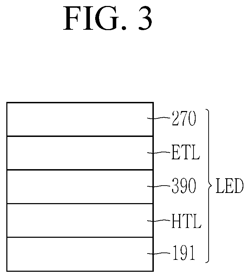

FIG. 3 shows an embodiment of a stacking structure of a light emitting diode LED of FIG. 2. In an embodiment and referring to FIG. 3, the light emitting diode LED may include the first electrode 191, a hole transport layer HTL, the light emitting layer 390, an electron transport layer ETL, and the second electrode 270.

In an embodiment, the first electrode 191 and the second electrode 270 may include a conductive oxide such as indium tin oxide (ITO), indium zinc oxide (IZO), zinc tin oxide (ZTO), copper indium oxide (CIO), copper zinc oxide (CZO), gallium zinc oxide (GZO), aluminium zinc oxide (AZO), tin oxide (SnO₂), zinc oxide (ZnO), or a combination thereof, calcium (Ca), ytterbium (Yb), aluminium (Al), silver (Ag), magnesium (Mg), samarium (Sm), titanium (Ti), gold (Au), or an alloy thereof, and a conductive polymer such as graphene, carbon nanotubes, or PEDOT:PSS. However, the first electrode 191 and the second electrode 270 are not limited thereto, and they may be formed with a stacked structure of at least two layers.

In an embodiment, the first electrode 191 may be a reflective electrode having a structure of ITO/Ag/ITO, and the second electrode 270 may be a transflective electrode including AgMg. Light generated from the light emitting layer EML may be reflected by the first electrode 191, which is a reflective electrode, and it may be resonated between the second electrode 270, which is a transflective electrode, and the first electrode 191 to be amplified. The resonated light is reflected from the first electrode 191 and is emitted to an upper surface of the second electrode 270.

In another embodiment, the second electrode 270 may be a reflective electrode having a structure of ITO/Ag/ITO, and the first electrode 191 may be a transflective electrode including AgMg. Light generated from the light emitting layer EML may be reflected by the second electrode 270, which is a reflective electrode, and it may be resonated between the first electrode 191, which is a transflective electrode, and the second electrode 270 to be amplified. The resonated light may be reflected from the second electrode 270 and emitted to an upper surface of the first electrode 191.

In an embodiment, the hole transport layer HTL may include at least one of m-MTDATA, TDATA, 2-TNATA, NPB(NPD), β-NPB, TPD, Spiro-TPD, Spiro-NPB, methylated-NPB, TAPC, HMTPD, TCTA (4,4',4"-tris(N-carbazolyl)triphenylamine, Pani/DBSA (Polyaniline/Dodecylbenzenesulfonic acid, PEDOT/PSS (Poly(3,4-ethylenedioxythiophene)/poly(4-styrenesulfonate), Pani/CSA (Polyaniline/Camphor sulfonic acid, and PANI/PSS (Polyaniline/Poly(4-styrenesulfonate). In another embodiment, the hole transport layer may include an alkali metal halide or an alkaline earth metal halide.

In an embodiment, the electron transport layer ETL may include at least one of ZnO, TiO₂, WO₃, SnO₂, and ZnO, TiO₂, WO₃, and SnO₂ to which at least one of Mg, Y, Li, Ga, and Al is doped. In detail, the electron transport layer ETL may include ZnO or ZnMgO.

In an embodiment and referring again to FIG. 1, a dummy printing area DPA is disposed in the non-display area NDA. The dummy printing area DPA represents a region in which the light emitting layer is not disposed, and where an acid ink 300 is disposed in the dummy printing area DPA. That is, the dummy printing area DPA is partitioned by the opening of the partition wall 360 in a similar way to the display area DA, and the light emitting layer is not disposed in the opening. In an embodiment, not the light emitting layer, but the acid ink 300 may be disposed in the dummy printing area DPA.

In an embodiment, the acid ink 300 may include a polymer resin and an acid material, wherein the acid material may be at least one of methacrylic acid, acrylic acid, and citric acid, but the invention is not limited thereto.

In an embodiment, the acid ink 300 may perform aging of the light emitting element disposed in the display area. That is, the aging of the light emitting element may be performed and a characteristic of the light emitting element may be improved by acid vapors output from the acid ink disposed in the non-display area. To be additionally described, the aging of the light emitting element represents a process for increasing performance and efficiency of the light emitting element by processing the acid vapors on the light emitting element.

In an embodiment and as described with reference to FIG. 2 and FIG. 3, the light emitting element including the quantum dots as the light emitting layer needs the improvement of performance of the element through an aging process as an essential process. The element may not be normally operated without the aging process. The display device, according to an embodiment, and the manufacturing method thereof may perform the aging of the light emitting element by a method for disposing the acid ink 300 in the non-display area NDA.

In an embodiment and referring to FIG. 1, a thickness measuring groove H1 may be disposed in the display area DA and the non-display area NDA. The acid ink 300 may be disposed in the thickness measuring groove H1 disposed in the non-display area NDA.

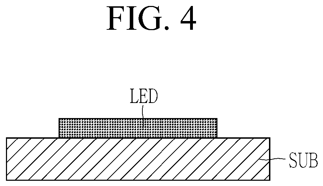

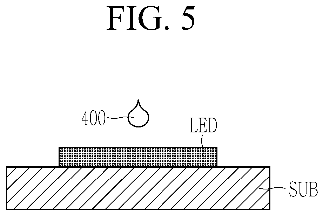

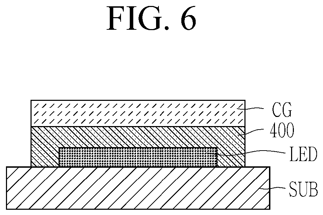

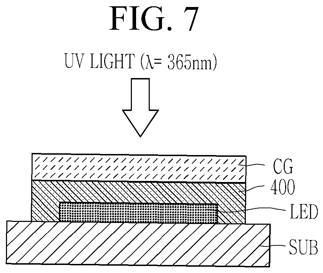

FIG. 4 to FIG. 7 show an aging process, according to an embodiment. Referring to FIG. 4, the light emitting diode LED is disposed on the substrate SUB. Referring to FIG. 5, a sealing resin 400 is applied on the light emitting diode LED, where the sealing resin 400 may include an acid material. Referring to FIG. 6, a cover glass CG is disposed on the sealing resin 400, and pressure is applied thereto so that the sealing resin 400 may be spread on the light emitting diode LED. Referring to FIG. 7, ultraviolet rays are irradiated to cure the sealing resin. In an embodiment, the light emitting diode LED may be aged according to the process shown in FIG. 4 to FIG. 7. However, it is difficult to apply the method to large-area display devices.

In an embodiment, regarding the display device and the manufacturing method thereof, the acid ink 300 is disposed in the dummy printing area DPA disposed in the non-display area NDA, and the light emitting element is aged through the acid ink 300. Therefore, as no additional process for the aging is required, the process is simple and may be applied to large-area display devices.

In an embodiment, the dummy printing area DPA disposed in the non-display area NDA controls the properties of films stacked in the display area DA, and is not further added for the aging process. That is, the display device, according to an embodiment and the manufacturing method thereof, may perform aging without forming an additional stacking structure for the aging process. Hence, the process is simple and is advantageous in mass production.

In an embodiment, the aging process improves performance of the light emitting layer including quantum dots and the light emitting element, and the performance of the light emitting element including quantum dots is improved by the acid vapor discharged from the acid ink 300 in the dummy printing area DPA. In detail, a defect of ZnMgO included in the electron transport layer may be reduced by the acid vapor.

Table 1 below expresses a first case (Embodiment 1) in which a surface treatment is not applied on the film of ZnMgO that is the electron transport layer of the light emitting element, a second case (Embodiment 2) in which the surface treatment is performed with polyacrylic acid (PAA) and citric acid (CtA), a third case (Embodiment 3) in which the surface treatment is performed with methacrylic acid (MAA), and a fourth case (Embodiment 4) in which the surface treatment is performed with a mixture of PAA and MAA by a ratio of about 8:2. The respective surface treatments are performed by a method for heating an acid material at about 120 °C for about two hours.

**Table 1**

| | Surface treatment | Fume |
|---|---|---|
| Embodiment 1 | - | 120 °C, 2 Hr |
| Embodiment 2 | PAA : CtA | |
| Embodiment 3 | only MAA | |
| Embodiment 4 | PAA : MAA (8:2) | |

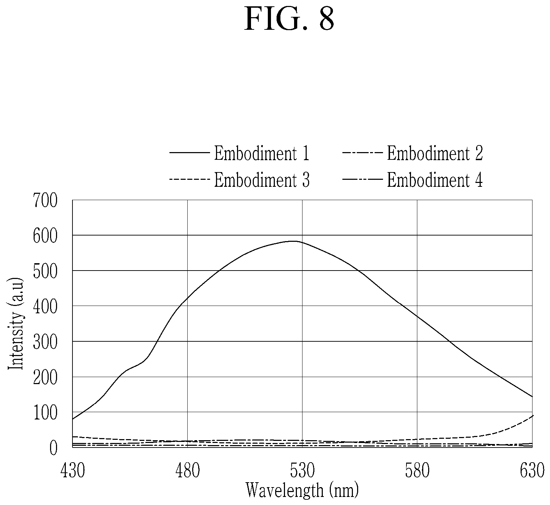

Defect emissions of the light emitting element according to Embodiment 1 to Embodiment 4 expressed in Table 1 were measured and the results are shown in FIG. 8. In an embodiment and referring to FIG. 8, it is found that the defect emission was observed in Embodiment 1 in which no additional surface treatment is performed, and the defect emission is scarcely able to be measured in Embodiments 2 to 4 in which the surface treatment by the acid vapor is performed-that is, it is found according to Table 1 and the result of FIG. 8, that the defect of ZnMgO is cured by the acid treatment.

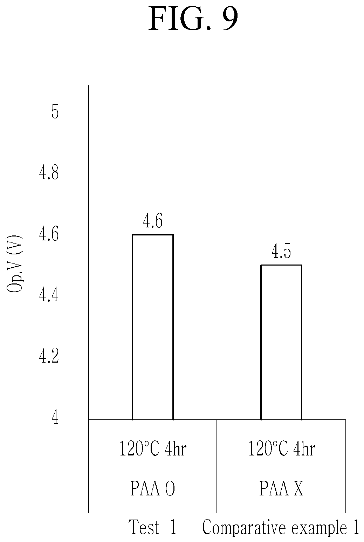

In an embodiment and as shown in Table 2 and FIG. 9 to FIG. 11, device characteristics depending on whether the PAA acid treatment is aged are compared. In the respective tests, a Comparative Example 1 shows the light emitting element on which no acid treatment is performed, and an Experimental Example 1 shows the light emitting element on which the acid treatment is performed by heating the PAA at 120 °C for four hours.

FIG. 9 shows a driving voltage (V) depending on whether the acid treatment is performed or not. In an embodiment and referring to FIG. 9, it is found that driving voltages of Experimental Example 1 in which the acid treatment is performed and Comparative Example 1 have similar levels.

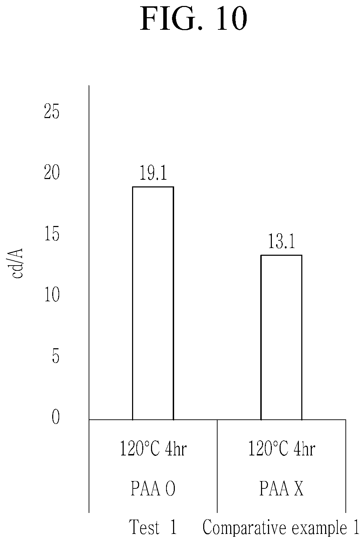

FIG. 10 shows an efficiency (Cd/A) depending on whether or not the acid treatment is performed. In an embodiment and referring to FIG. 10, it is found that Experimental Example 1 in which the acid treatment is performed generates higher efficiency than Comparative Example 1.

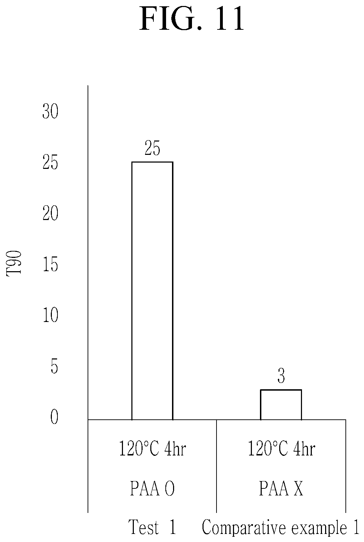

FIG. 11 shows a life-span T90 depending on whether or not an acid treatment is performed. In an embodiment and referring to FIG. 11, it is found that Experimental Example 1 in which the acid treatment is performed has an improved life-span than Comparative Example 1.

When the characteristics of Comparative Example 1 are set to be 100% with respect to the result of FIG. 9 to FIG. 11, relative values of Experimental Example 1 are expressed in Table 2 immediately below:

**Table 2**

| | Driving voltage (V) | Efficiency (Cd/A) | Life-span |
|---|---|---|---|
| Comparative Example 1 | 100% | 100% | 100% |
| Experimental Example 1 | 102% | 145% | 833% |

As may be seen in Table 2, when the acid treatment is performed, the driving voltage has a similar level, and the efficiency and life-span are substantially improved. That is, the display device, according to an embodiment, has acid ink in the non-display area and the defect of the light emitting element disposed in the display area may be cured by the acid vapor discharged from the acid ink, the performance of the light emitting element may be secured, and the characteristic thereof may be improved.

FIG. 1 shows an embodiment where the acid ink is disposed in the dummy printing area DPA of the non-display area NDA, which is an example and which is not limited thereto.

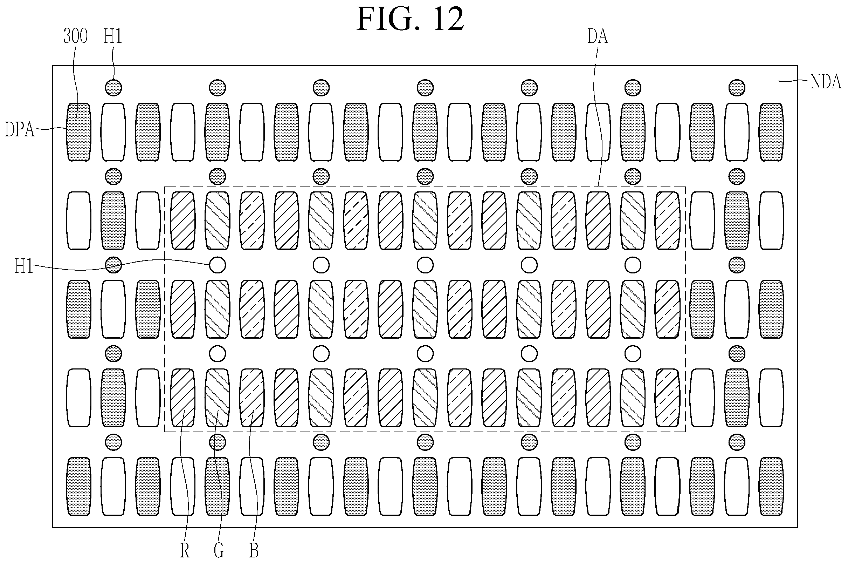

FIG. 12 shows the same region as that in FIG. 1, according to another embodiment. In an embodiment and referring to FIG. 12, the display device corresponds to that shown in FIG. 1 except that the acid ink 300 is disposed in a predetermined portion of the dummy printing area DPA disposed in the non-display area NDA. No detailed descriptions on the same components will be provided.

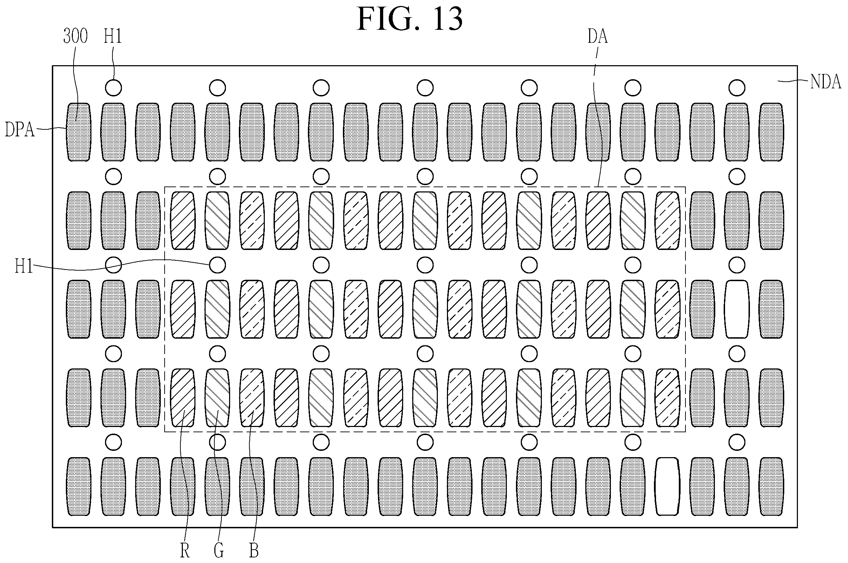

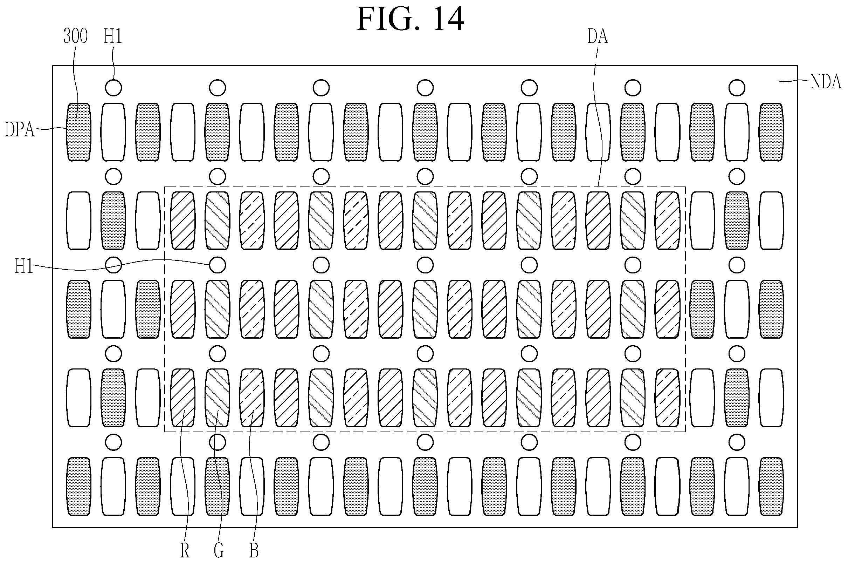

It has been described in the previous embodiment that the acid ink 300 is disposed in the dummy printing area DPA of the non-display area and the thickness measuring groove H1, and in another embodiment, the acid ink 300 may not be disposed in the thickness measuring groove H1. FIG. 13 shows the same region as that in FIG. 1, according to another embodiment, and FIG. 14 shows the same region as that in FIG. 12, according to yet another embodiment. In an embodiment and referring to FIG. 13, the display device corresponds to the embodiment of FIG. 1 except that the acid ink 300 is not disposed in the thickness measuring groove H1. No detailed descriptions on the same components will be provided. In an embodiment and referring to FIG. 14, the display device corresponds to the embodiment of FIG. 12 except that the acid ink 300 is not disposed in the thickness measuring groove H1. No detailed descriptions on the same components will be provided.

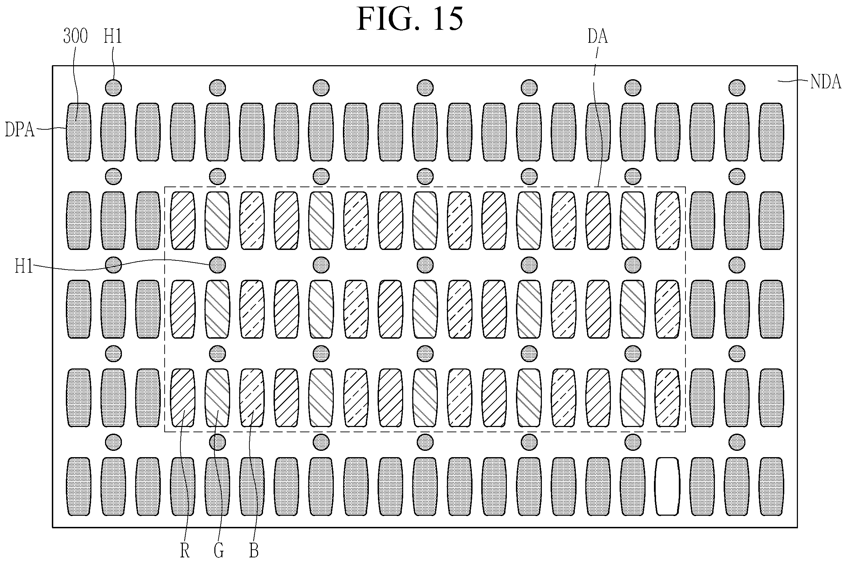

The previous embodiment shows that the acid ink 300 is not disposed in the display area DA, and the acid ink 300 may be disposed in the display area DA in an embodiment. FIG. 15 shows the same region as that in FIG. 1, according to another embodiment. In an embodiment and referring to FIG. 15, the display device corresponds to the embodiment of FIG. 1 except that the acid ink 300 is disposed in the thickness measuring groove H1 disposed in the display area DA. No detailed descriptions on the same components will be provided.

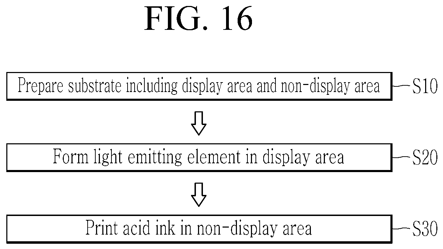

A method for manufacturing a display device, according to an embodiment, will now be described. FIG. 16 shows a process for manufacturing a display device, according to an embodiment. In an embodiment and referring to FIG. 16, the method for manufacturing a display device includes a step (S 1 0) of preparing a substrate including a display area and a non-display area, a step (S20) of forming a light emitting element in the display area, and a step (S30) of printing an acid ink in the non-display area.

In an embodiment, the substrate prepared in the step (S10) of preparing a substrate including a display area and a non-display area is like what is shown in FIG. 1. A cross-section of the light emitting element formed in step (S20) for forming a light emitting element in the display area corresponds to that which is described with reference to FIG. 2 and FIG. 3, where the light emitting element may include a light emitting layer including quantum dots, and where an electron transport layer may be disposed on the light emitting layer. The electron transport layer may include ZnO and ZnMgO.

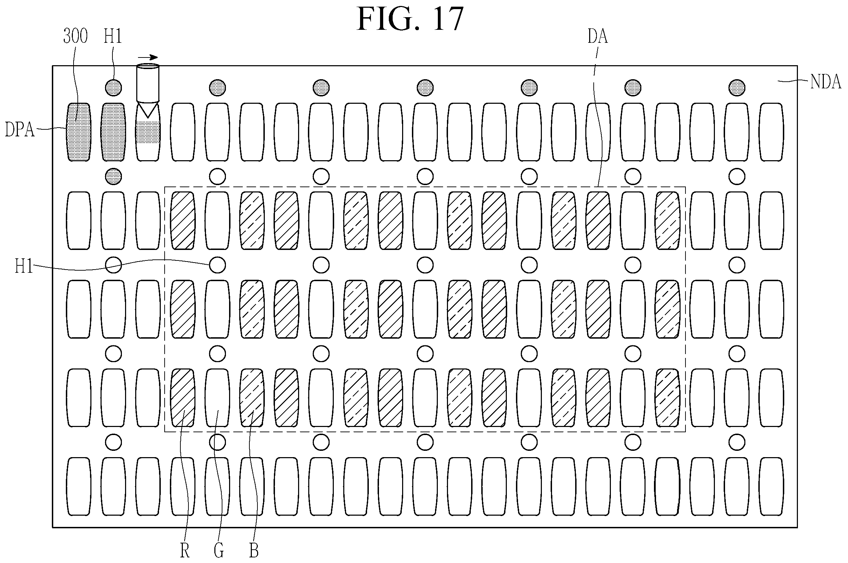

The acid ink is printed in the non-display area (S30), where the stage for printing the acid ink in the non-display area may be performed, as shown in FIG. 17, by a method inputting the acid ink 300 to the dummy printing area DPA disposed in the non-display area NDA.

**In** this stage, the acid vapor is discharged from the acid ink disposed in the non-display area, according to an embodiment. The acid vapor may perform aging of the light emitting element of the neighboring display device and may improve performance of the light emitting element.

The detailed effect of aging is like what has been described above. That is, in an embodiment, the defect of ZnMgO included in the electron transport layer may be reduced and performance of the light emitting element may be improved by the acid vapor.

As described above, the display device, according to an embodiment, and the method for manufacturing the display device have disposed the acid ink 300 in the dummy printing area DPA of the non-display area NDA. The aging of the light emitting element may be performed and the performance of the light emitting element may be improved by the acid vapor generated from the acid ink 300. The display device and the manufacturing method require no additional process for the aging, so the process is simplified.

While the invention has been described in connection with what is presently considered to be practical embodiments, it is to be understood that the invention is not limited to the disclosed embodiments, and it is intended to cover various other modifications and equivalent arrangements included within the scope of the invention. Therefore, the scope of the invention is not limited to the contents described in the detailed description of the specification. Moreover, the embodiments or parts of the embodiments may be combined in whole or in part without departing from the scope of the invention.

## Claims

1. A display device comprising:
a substrate including a display area and a non-display area;
a light emitting element disposed in the display area; and
a dummy printing area disposed in the non-display area,
wherein the light emitting element includes quantum dots, and
wherein an acid ink is disposed in the dummy printing area.

2. The display device of claim 1, wherein
the acid ink includes a polymer resin and an acid material.

3. The display device of claim 2, wherein
the acid material includes at least one of a methacrylic acid, an acrylic acid, and a citric acid.

4. The display device of any one of claims 1 to 3, wherein
an acid ink is disposed on only one predetermined portion of the dummy printing area.

5. The display device of any one of claims 1 to 4, further comprising
a thickness measuring groove disposed in the non-display area,
wherein the acid ink is disposed in the thickness measuring groove.

6. The display device of any one of claims 1 to 5, further comprising
a thickness measuring groove disposed in the display area,
wherein the acid ink is disposed in the thickness measuring groove.

7. The display device of any one of claims 1 to 6, wherein
the light emitting element includes a first electrode, a hole transport layer, a light emitting layer, an electron transport layer, and a second electrode, and
wherein the light emitting layer includes quantum dots.

8. The display device of claim 7, wherein
the electron transport layer includes ZnO and ZnMgO.

9. The display device of any one of claims 1 to 8, wherein
the acid ink is configured to discharge acid vapor.

10. An electronic device, comprising:
a display device, wherein the display device includes,
a substrate including a display area and a non-display area;
a light emitting element disposed in the display area; and
a dummy printing area disposed in the non-display area,
wherein the light emitting element includes quantum dots, and
wherein an acid ink is disposed in the dummy printing area.

11. The electronic device of claim 10, wherein
the acid ink includes a polymer resin and an acid material.

12. The electronic device of claim 11, wherein
the acid material includes at least one of a methacrylic acid, an acrylic acid, and a citric acid.

13. The electronic device of any one of claims 10 to 12, wherein
an acid ink is disposed on only one predetermined portion of the dummy printing area.

14. The electronic device of any one of claims 10 to 13, wherein the display device further comprises,
a thickness measuring groove disposed in the non-display area,
wherein the acid ink is disposed in the thickness measuring groove.

15. The electronic device of any one of claims 10 to 14, wherein the display device further comprises,
a thickness measuring groove disposed in the display area,
wherein the acid ink is disposed in the thickness measuring groove
